(19) Europäisches Patentamt
European Patent Office
Office européen des brevets

(11) **EP 0 729 225 B1**

(12) **EUROPÄISCHE PATENTSCHRIFT**

(45) Veröffentlichungstag und Bekanntmachung des Hinweises auf die Patenterteilung:
**03.05.2000 Patentblatt 2000/18**

(51) Int Cl.⁷: **H03F 3/343**

(21) Anmeldenummer: **96101386.9**

(22) Anmeldetag: **01.02.1996**

(54) **Faltungsverstärker für den Aufbau eines A/D-Umsetzers**

Folding amplifier for an A/D converter

Amplificateur à pliage pour un convertisseur A/N

(84) Benannte Vertragsstaaten:
**AT CH DE FR GB IT LI**

(30) Priorität: **22.02.1995 DE 19506020**

(43) Veröffentlichungstag der Anmeldung:
**28.08.1996 Patentblatt 1996/35**

(73) Patentinhaber: **TEMIC Semiconductor GmbH
74072 Heilbronn (DE)**

(72) Erfinder: **Böhme, Rolf, Dr.
D-74177 Bad Friedrichshall (DE)**

(74) Vertreter: **Maute, Hans-Jürgen, Dipl.-Ing.
Daimler-Benz Aktiengesellschaft,
FTP/H,
Postfach 35 35
74025 Heilbronn (DE)**

(56) Entgegenhaltungen:
**DE-A- 3 413 456        GB-A- 2 030 017
US-A- 4 379 285        US-A- 4 667 180**

**Beschreibung**

Die Erfindung betrifft einen Faltungsverstärker gemäß dem Oberbegriff des Patentanspruches 1, dem als Eingangssignal ein Stromsignal zugeführt wird und als Ausgangssignal ein Stromsignal mit V-förmigem Verlauf erzeugt. Ferner betrifft die Erfindung einen A/D-Umsetzer, der einen solchen Faltungsverstärker in seinem Aufbau verwendet.

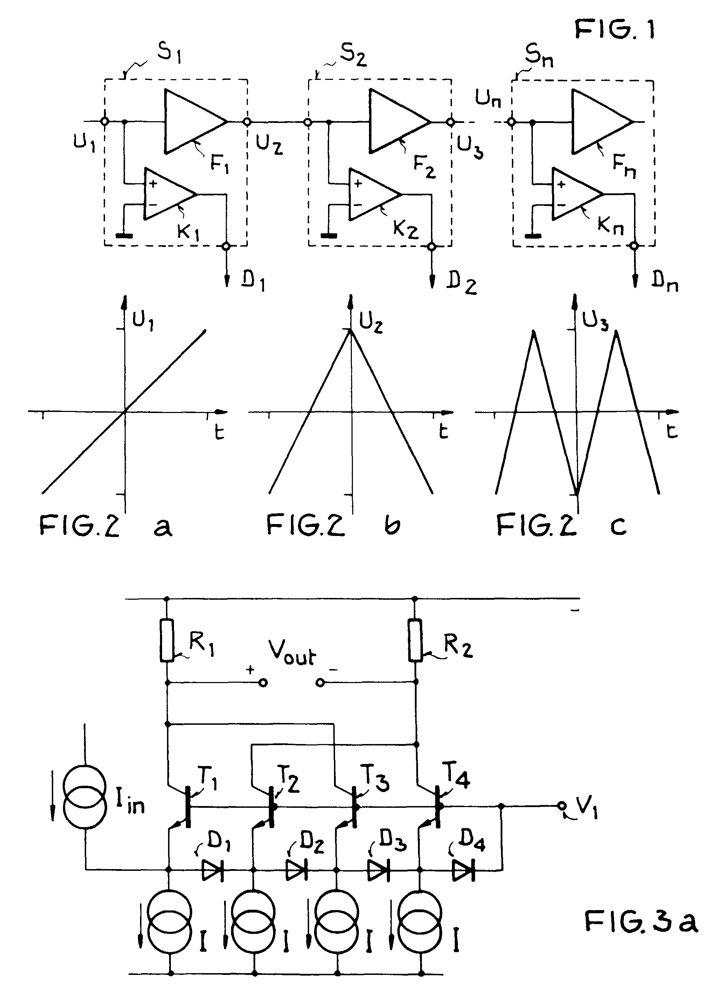

Die Verwendung von Faltungsverstärkern für den Aufbau von A/D-Umsetzern ist beispielsweise aus Elektronik 1976, Heft 12, Seiten 36-42 bekannt, wo ein A/D-Umsetzer in Kaskadenstruktur gemäß Figur 1 beschrieben ist, dessen Stufen $S_i$ (i=1, ..., n) jeweils aus einem Faltungsverstärker $F_i$ (i=1, ..., n) und einem Komparator $K_i$ (i=1, ..., n) aufgebaut ist. Bei einem zu digitalisierenden Analogsignal $U_1$ wird einerseits mittels des Komparators $K_1$ das Vorzeichen festgestellt und andererseits von dem Faltungsverstärker $F_1$ ein Ausgangssignal $U_2$ gebildet und der zweiten Stufe $S_2$ zugeführt, um dort der gleichen Verarbeitung unterworfen zu werden. An jedem der Ausgänge der Komparatoren $K_i$ erscheint ein Digitalwert je nach dem Vorzeichen der Spannung, so daß diese Digitalwerte $D_i$ (i=1, ..., n) ein Digitalwort ($D_1$, $D_2$, ... $D_n$) bilden.

Die Faltungsverstärker $F_i$ (i=1, ..., n) erzeugen jeweils eine V-Kennlinie durch Betragsbildung und Verschiebung, wie es die übertragungsfunktionen gemäß der Figuren 2b und 2c zeigen. Hiernach wird ein linearer Eingangsspannungsbereich, wie es in Figur 2a dargestellt ist, durch den Faltungsverstärker $F_1$ der ersten Stufe $S_1$ in eine einfache Faltung gemäß Figur 2b und mit dem Faltungsverstärker $F_2$ der zweiten Stufe $S_2$ in eine zweifache Faltung gemäß Figur 2c umgesetzt. In der letzten Stufe $S_n$ erzeugt der Faltungsverstärker $F_n$ eine n-fache Faltung.

Das von den Komparatoren $K_i$ ausgegebene Bit-Muster entspricht dem sogenannten Gray-Code.

In IEEE Journal of Solid-State circuits, Vol. sc-14, No. 6, Dec. 1979, Seiten 938 bis 943 ist ein Faltungsverstärker zum Aufbau eines schnellen 7-Bit A/D-Umsetzers beschrieben. Dieser Faltungsverstärker und dessen Übertragungsfunktion ist in den Figuren 3a und 3b beschrieben. Dieser Faltungsverstärker besteht aus 4 npn-Transistoren $T_1$ - $T_4$, deren Basen an eine Hilfsspannungsquelle $V_1$ angeschlossen sind. Weiterhin ist jeder Emitter dieser Transistoren $T_1$ bis $T_4$ mit einer Referenzstromquelle verbunden, wobei diese Referenzstromquellen jeweils einen Strom I gleichen Betrages erzeugen. Weitere wichtige Elemente dieser Schaltung stellen drei Dioden $D_1$ bis $D_3$ dar, die jeweils zwischen den Emittern zweier Transistoren $T_1$ und $T_2$, $T_2$ und $T_3$, bzw. $T_3$ und $T_4$ geschaltet sind. Schließlich sind die Kollektoren der beiden Transistoren $T_1$ und $T_3$ auf einen gemeinsamen Kollektorwiderstand $R_1$ und entsprechend die Kollektoren der beiden Transistoren $T_2$ und $T_4$ ebenfalls auf einen gemeinsamen Kollektorwiderstand $R_2$ geführt. Die Ausgangsspannung $V_{out}$ bildet die Differenzspannung an diesen beiden Kollektorwiderständen $R_1$ und $R_2$.

Die Schaltung ist für einen Eingangsstrombereich $0 \leq I_{in} \leq 4I$ vorgesehen. Im Bereich $0 \leq I_{in} \leq I$ fließt $I-I_{in}$ durch den Transistor $T_1$, während die Transistoren $T_2$ bis $T_4$ den vollen Strom I führen. Ab $I_{in} = I$ wird $T_1$ stromlos. Das Emitterpotential von $T_1$ hebt sich an und die Diode 1 wird leitend. Im Bereich $I \leq I_{in} \leq 2I$ fließt $2I-I_{in}$ durch $T_2$. $T_1$ ist stromlos, $T_3$ und $T_4$ führen den Strom I. Mit weiter steigendem Strom $I_{in}$ wird dann auch $T_2$ stromlos und $T_3$ übernimmt über die dann leitende Diode $D_2$ die Differenzbildung im Intervall $2I \leq I_{in} \leq 3I$. Ab $I_{in} = 4I$ sind alle Transistoren gesperrt und die Diode $D_4$ verhindert ein unbegrenztes Ansteigen der Eingangsspannung. Aus der Überlagerung der Kollektorströme in den gemeinsamen Kollektorwiderständen ergibt sich ein Spannungsverlauf der Ausgangsspannung gemäß Fig. 3b. Die Überwachung der Diodenspannung durch 4 Komparatoren ergibt einen Informationsgehalt von 2 Bit.

Ein digitales Ausgangssignal ergibt sich dadurch, daß mittels Komparatoren jeweils der nichtleitende bzw. leitende Zustand der Dioden $D_i$ mittels Komparatoren festgestellt wird. Die Ausgangsspannung $V_{out}$ kann einem weiteren Faltungsverstärker oder einem A/D-Parallelumsetzer zugeführt werden.

Der in Figur 3a beschriebene Faltungsverstärker wird zum Aufbau eines 2-stufigen A/D-Umsetzers verwendet.

Die Aufgabe der Erfindung liegt darin, einen Faltungsverstärker der eingangs genannten Art anzugeben, der einen einfachen Schaltungsaufbau aufweist, für niedrige Versorgungsspannungen geeignet ist, dynamisch gleichartig arbeitet und in vielfältigster Weise für den Aufbau eines A/D-Umsetzers geeignet ist.

Diese Lösung ist mit den kennzeichnenden Merkmalen des Patentanspruches 1 gegeben. Hiernach wird das durch Differenzbildung mit dem Referenzstrom erzeugte Stromdifferenzsignal als Steuersignal sowohl einer ersten stromgesteuerten Stromquelle, die das Vorzeichen des Steuersignales umkehrt, als auch einer zweiten stromgesteuerten Stromquelle, die jedoch das Vorzeichen des Steuersignales beibehält, zugeführt, wobei bei positivem Vorzeichen des Stromdifferenzsignales die erste Stromquelle diesen Strom und bei negativem Vorzeichen des Stromdifferenzsignales die zweite Stromquelle diesen Strom übernimmt. Der mit dem Vorzeichenwechsel des Eingangsstromes verbundene Spannungshub kann wesentlich kleiner als in einer Schaltung gemäß dem Stand der Technik gehalten werden, so daß die Umschaltgeschwindigkeit erhöht wird und die Schaltung mit Versorgungsspannungen bis herunter zu 1.2 V dimensionierbar ist. Die Ausgänge der beiden stromgesteuerten Stromquellen werden auf den Ausgang des Faltungsverstärkers geführt. Vorzugsweise kann auch eine dritte stromgesteuerte Stromquelle mit Vorzeichenumkehr eingesetzt werden, deren Eingang mit den Ausgängen der ersten und zweiten Stromquelle verbunden ist und deren Ausgang das Ausgangssignal des Faltungsverstärkers führt.

Vorzugsweise kann die erste und dritte stromgesteuerte Stromquelle als Stromspiegel ausgebildet werden.

Zur Realisierung der Faltungsgleichung

$$I_a = 2x \left| I_e - I_{ref} \right|$$

kann bei einer vorteilhaften Ausführungsform der Erfindung der Stromverstärkungsfaktor der dritten, als Stromspiegel ausgebildeten Stromquelle auf den Wert 2 eingestellt werden, wenn die Verstärkungsfaktoren der ersten und zweiten Stromquelle den Wert 1 aufweisen.

Weitere vorteilhafte Ausführungsformen der Erfindung ergeben sich aus weiteren abhängigen Patentansprüchen.

Im folgenden soll die Erfindung anhand von Ausführungsbeispielen im Zusammenhang mit den Zeichnungen dargestellt und erläutert werden. Es zeigen:

Figur 1 einen bekannten A/D-Faltungsumsetzer in Kaskadenstruktur,

Figur 2 die Übertragungsfunktionen für den Kaskadenumsetzer gemäß Figur 1,

Figur 3 einen bekannten Faltungsverstärker mit seiner Übertragungsfunktion,

Figur 4 zeigt ein Prinzipschaltbild des erfindungsgemäßen Faltungsverstärkers,

Figur 5 zeigt eine schaltungsmäßige Ausführungsform des Faltungsverstärkers nach Figur 4,

Figur 6 ein Schaltungsbeispiel zur Erzeugung der Hilfsspannung $U_{H1}$ gemäß Figur 5,

Figur 7 eine verbesserte Schaltungsausführung des Faltungsverstärkers nach Figur 5,

Figur 8 ein Ausführungsbeispiel gemäß Figur 5 mit verbessertem Stromspiegel 4 und

Figur 9 ein weiteres Ausführungsbeispiel des erfindungsgemäßen Faltungsverstärkers mit gegenüber dem Ausführungsbeispiel nach Figur 5 verbessertem Verhalten im Nulldurchgang des Differenzstromes $I_d$.

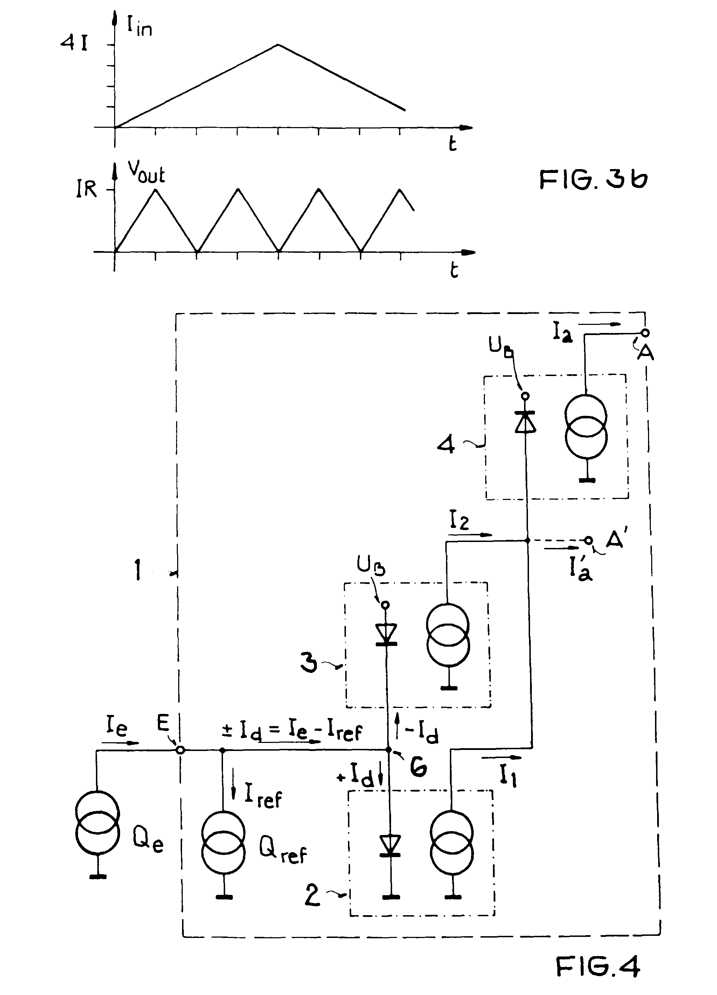

In Figur 4 ist ein Faltungsverstärker mit dem Bezugszeichen 1 bezeichnet, dessen Eingang E ein von einer Stromquelle $Q_e$ erzeugtes Eingangssignal $I_e$ zugeführt wird. Von diesem Eingangssignal $I_e$ wird vorausgesetzt, daß es hinsichtlich des eingetragenen Zählpfeiles nicht negativ wird und einen Maximalwert $I_{emax}$ erreichen kann. Vom Eingangsstrom $I_e$ wird ein von einer Referenzstromquelle $Q_{ref}$ erzeugter Referenzstrom $I_{ref}$ subtrahiert. Der Wert dieses Referenzstromes $I_{ref}$ beträgt $1/2 \times I_{emax}$, so daß dem Rest der Schaltung ein Stromdifferenzsignal $I_d$ zufließt, das gleichermaßen positiv oder negativ sein kann.

Dieses Stromdifferenzsignal $I_d$ wird zur Bildung des Betrages $\left| I_e - I_{ref} \right|$ einem Schaltungsknoten 6 zugeführt, der mit zwei stromgesteuerten Stromquellen 2 und 3 verbunden ist. Dabei stellt der Differenzstrom $I_d$ den Steuerstrom für diese beiden stromgesteuerten Stromquellen 2 und 3 dar. Die Stromquelle 2 ist so aufgebaut, daß sie das Vorzeichen des Steuersignals umkehrt, während die zweite Stromquelle 3 das Vorzeichen des ihr zugeführten Steuersignales beibehält. Wenn also der Differenzstrom $I_d$ ein positives Vorzeichen aufweist, also der Strom zum Knoten 6 hinführt, übernimmt die "invertierende" Stromquelle 2 diesen Strom und erzeugt einen Ausgangsstrom $I_1$ in umgekehrter Richtung. Weist der Differenzstrom $I_d$ dagegen ein negatives Vorzeichen auf, führt dieser also von dem Knoten 6 weg, übernimmt die "nichtinvertierende" Stromquelle 3 diesen Strom und erzeugt einen Ausgangsstrom $I_2$ in gleicher Richtung. Somit symbolisiert die eingangsseitige Diode der Stromquelle 2, daß sie positive, dem Eingang zufließende Ströme aufnimmt, während die Diode der Stromquelle 3 vom Eingang abfließende Ströme aufnimmt. Da die Ausgänge der beiden Stromquellen 2 und 3 verbunden sind, ist die Summe der beiden Ausgangsströme $I_1$ und $I_2$ immer positiv, unabhängig von der Richtung des Differenzstromes $I_d$. Weisen die beiden Stromquelle 2 und 3 jeweils eine Stromverstärkung mit dem Betrag 2 auf, so erfüllt die Schaltung die Faltungsformel

$$I_a = 2 \times \left| I_e - I_{ref} \right|,$$

wobei die zusammengefassten Ausgänge der beiden Stromquellen 2 und 3 den Ausgangsstrom $I_a$ liefernden Ausgang A' des Faltungsverstärkers 1 bilden. Weisen jedoch die Stromverstärkungen der beiden Stromquellen 2 und 3 lediglich den Betrag 1 auf, so muß noch - wie in Figur 4 dargestellt - eine verstärkende Funktionseinheit 4 nachgeschaltet werden, die gemäß Figur 4 als stromgesteuerte Stromquelle mit Vorzeichenumkehr ausgebildet ist. Der Ausgang A dieser Stromquelle 4 liefert den Ausgangsstrom $I_a$.

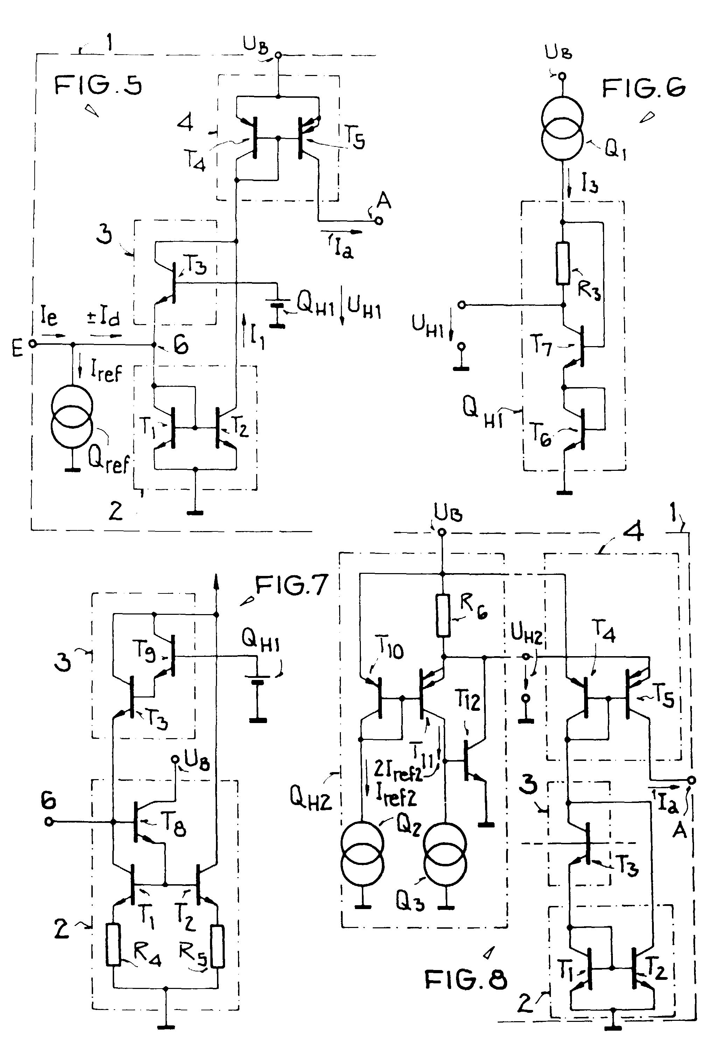

Eine einfache schaltungstechnische Ausführung des Prinzipschaltbildes nach Figur 4 eines Faltungsverstärkers 1 zeigt Figur 5 mit bipolaren Transistoren. Bei diesem Faltungsverstärker 1 ist die stromgesteuerte "invertierende" Stromquelle 2 als einfacher Stromspiegel mit zwei npn-Transistoren $T_1$ und $T_2$ ausgeführt, wobei eingangsseitig dieses Stromspiegels der Transistor $T_1$ als Diode geschaltet ist und der Transistor $T_2$ den Ausgangstransistor bildet.

Die "nichtinvertierende" Stromquelle 3 wird von einem npn-Transistor $T_3$ in Basisschaltung gebildet, indem dessen Basis an eine, eine Hilfsspannung $U_{H1}$ erzeugende Hilfsspannungsquelle $Q_{H1}$ angeschlossen ist, dessen Emitter mit dem Schaltungsknoten 6 verbunden ist und dessen Kollektor den Ausgang der Stromquelle 2 bildet. Um schließlich die erforderliche Stromverstärkung mit dem Wert 2 zu erreichen, ist noch ein verstärkender Stromspiegel 4 als weitere Stromquelle mit den pnp-Transistoren $T_4$ und $T_5$ nachgeschaltet, dem die Summe der beiden Ausgangsströme $I_1$ und $I_2$ der beiden Stromquellen 2 und 3 als Eingangsstrom zugeführt wird. Dabei kann der Ausgangstransistor $T_5$ gegenüber dem als Diode geschalteten Eingangstransistor $T_4$ entweder die doppelte Basis-Emitter-Fläche aufweisen oder aus zwei parallel geschalteten Transistoren bestehen.

Ein dem Schaltungsknoten 6 zufließender Strom $+I_d$ wird von dem als Diode geschalteten Transistor $T_1$ aufgenommen. Gegenüber dem Referenzpunkt Masse entsteht am Schaltungsknoten 6 die Flußspannung $U_{6+}$ der Transistordiode $T_1$. Ein vom Schaltungsknoten 6 abfließender Strom $-I_d$ nimmt dagegen seinen Weg über den Transistor $T_3$ der Stromquelle 3. Die Flußspannung der Basis-Emitter-Diode $U_{BE}$ des Transistors $T_3$ subtrahiert sich von der Hilfsspannung $U_{H1}$, sodaß eine Spannung $U_{6-} = U_{H1} - U_{BE}$ am Knoten 6 gegenüber Masse entsteht.

Wird ein solcher Faltungsverstärker 1 für den Aufbau eines weiter unten zu beschreibenden A/D-Faltungsumsetzers mit einer Kaskadenstruktur verwendet, so ist ein vorteilhafter Wert der Hilfsspannung $U_{H1}$ dann erreicht, wenn die beiden Dioden auch ohne Eingangsstrom einen sehr kleinen Strom führen, der einen gewissen Bruchteil des kleinsten Stromschrittes, den der Umsetzer noch auflösen soll, betragen darf, beispielsweise 20%. Ist die Hilfsspanung $U_{H1}$ kleiner, so entsteht ein unnötig großer Spannungshub $U_{6+} - U_{6-}$ bei einer Richtungsumkehr des Differenzstromes $I_d$, was die Arbeitsgeschwindigkeit vermindert.

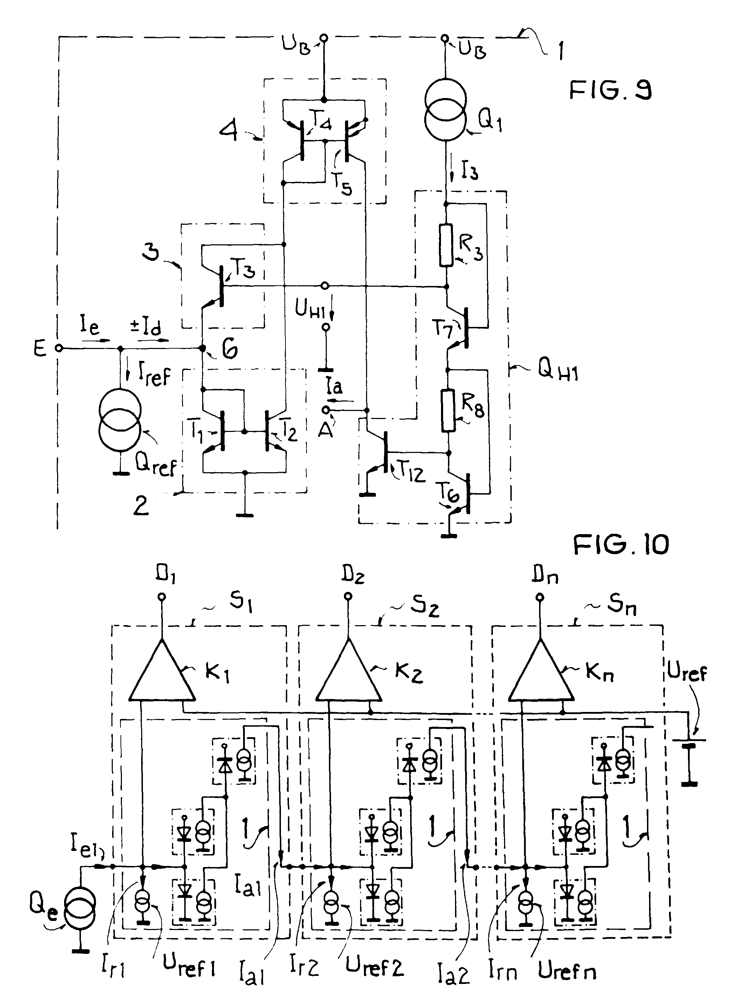

Der Faltungsverstärker gemäß Figur 5 ist bereits ab etwa 1V Versorgungsspannung betriebsfähig, womit Anwendungen in der Mikroleistungstechnik leicht möglich sind. Durch die Wahl der Hilfsspannung $U_{H1}$ kann man den Ruhestrom im Nulldurchgang des Differenzstromes $I_d$ und damit die Auflösung frei wählen, weshalb nur noch die Ungenauigkeiten der Verstärkungsfaktoren von Bedeutung sind. Dient ein solcher Faltungsverstärker zusammen mit einem Komparator dem Aufbau einer Stufe eines Faltungsumsetzers, wie dies weiter unten im Zusammenhang mit Figur 10 beschrieben wird, so müssen an einen solchen Komparator keine großen Anforderungen hinsichtlich Verstärkung und Offsetspannung gestellt werden, da im Nulldurchgang dieses Differenzstromes $I_d$ die Spannung sehr rasch von $U_{6+}$ zu $U_{6-}$ wechselt.

Eine zweckmäßige Schaltungsrealisierung zur Erzeugung der Hilfsspannung $U_{H1}$ zeigt die Figur 6. Eine Stromquelle $Q_1$ treibt einen Strom $I_3$ durch zwei in Serie und jeweils als Diode geschaltete npn-Transistoren $T_6$ und $T_7$. Ein in den Kollektorkreis des Transistors $T_7$ eingefügter Widerstand $R_3$ erzeugt einen Spannungsabfall, der sich von der Summe der beiden Dioden-Flußspannungen subtrahiert. Die um diesen Spannungsabfall reduzierte Summe der Flußspannungen wird als Hilfsspannung $U_{H1}$ verwendet. Ohne diesen Widerstand $R_3$ würde der in den Stromquellen 2 und 3 fließende Ruhestrom bei untereinander gleichen Transistoren etwa dem Strom $I_3$ der Stromquelle $Q_1$ entsprechen. Bei Verwendung von Siliziumtransistoren wird der durch den Widerstand $R_3$ fließende Ruhestrom bei Zimmertemperatur jeweils um eine Zehnerpotenz für 120mV reduziert.

Ein Faltungsverstärker nach Figur 5 unterliegt einer Reihe von Fehlereinflüssen. Die Stromübertragungsfaktoren $A_1$ und $A_2$ der Stromquellen 2 und 3, die im Idealfall $A_1 = -1$ und $A_2 = 1$ sein sollten, sind normalerweise im Betrag kleiner als 1. Zwar kann ein Minderwert durch eine Verstärkung >2 des nachfolgenden Stromspiegels 4 kompensiert werden, nicht aber ein Unterschied in den Beträgen ($|a_1|$, $|a_2|$). Figur 7 zeigt hierzu einige Verbesserungen.

In Figur 7 wird anstatt des einfachen Transistors $T_3$ in der "nichtinvertierenden" Stromquelle 3 eine aus zwei npn-Transitoren $T_3$ und $T_9$ aufgebaute Darlington-Stufe verwendet, wodurch der Fehler dieser Stromquelle 3 sehr viel kleiner wird. Ähnlich führt die Zufügung eines Emitterfolgers $T_8$ im Stromspiegel der "invertierenden" Stromquelle 2 zu einer Verminderung des durch die endliche Stromverstärkung bedingten Fehlers. Mit Emitterwiderständen $R_4$ und $R_5$ läßt sich darüberhinaus der Einfluß einer Offset-Spannung zwischen den beiden Transistoren $T_1$ und $T_2$ dieser Stromquelle 2 vermindern. Eine weitere Reduzierung von Fehlereinflüssen ergäbe die Verwendung eines für den Fachmann bekannten Wilson-Stromspiegels, der jedoch in der Figur nicht gezeigt ist.

In einer bipolar integrierten Schaltung mit lateralen pnp-Transistoren ist der verstärkende Stromspiegel 3 in der Regel am stärksten fehlerbehaftet, weil die Stromverstärkung lateraler Transistoren niedriger ist, stärker vom Arbeitspunkt abhängt und außerdem die durch den Early-Effekt beschriebene Spannungsabhängigkeit des Kollektorstromes viel größer ist. Gemäß Figur 8 ist deshalb vorgesehen, dem Ausgangstransistor $T_5$ des Stromspiegels 4 eine größere Fläche als die zweifache gegenüber dem als Diode geschalteten Eingangstransistor $T_4$ des Stromspiegels 4 zu geben und gleichzeitig den Emitter dieses Transistors $T_5$ an eine Hilfsspannung $U_{H2}$ zu legen, durch die die Stromverstärkung genau auf einen gewünschten Wert eingestellt wird. Die dazu nötige Hilfsspannung $U_{H2}$ kann durch eine ebenfalls in Figur 8 dargestellte Referenzschaltung $Q_{H2}$ erzeugt werden, die mit einem zur Stromquelle 4 gleichartigen Stromspiegel mit zwei pnp-Transistoren $T_{10}$ und $T_{11}$ aufgebaut ist. Dieser Stromspiegel wird von zwei Referenzsstromquellen $Q_2$ und $Q_3$ gespeist, die jeweils einen Referenzstrom $I_{ref2}$ und $2 \times I_{ref2}$ erzeugen, wodurch das gewünschte Stromverhältnis festgelegt ist. Die Hilfsspannung $U_{H2}$ wird durch einen als npn-Transistor $T_{12}$ in Emitter-Schaltung mit einem Kollektorwiderstand $R_6$ aufgebauten Verstärker erzeugt, dessen Basis als Eingang mit dem Verbindungspunkt des Kollektors des Ausgangstransistors $T_{11}$ mit der Stromquelle

$Q_3$ angeschlossen ist und dessem Kollektor als Ausgang die gewünschte Hilfsspannung $U_{H2}$ entnommen wird.

Ein besonders kritischer Punkt in allen bisher beschriebenen Schaltungen ist der Nulldurchgang des Differenzstromes $I_d$. In dem Faltungsverstärker nach Figur 5 werden die Ströme in der Umgebung des Nulldurchganges in den Stromquellen 2, 3 und 4 sehr klein, womit häufig ein starker Abfall der Stromverstärkung verbunden ist. Bei bipolaren Transistoren führen Leckströme manchmal zu störenden Einflüssen in der Schaltung. Diese Störungen vermindern die Nullpunktschärfe des Ausgangsstromes $I_a$ und reduzieren in einem D/A-Umsetzer dessen erreichbare Auflösung. Um diesen Störungen entgegenzuwirken, wird gemäß Figur 9 durch entsprechende Wahl der HilfsSpannung $U_{H1}$ ein bestimmter Ruhestrom erzeugt, der vom Ausgangsstrom des Stromspiegels 4 subtrahiert wird. Ausgehend von der Schaltung nach Figur 6 wird zur Erzeugung eines Kompensationsstromes auch an dem Transistor $T_6$ ein Kollektorwiderstand $R_8$ eingefügt um an der Verbindung zum Kollektor dieses Transistors $T_6$ die Basis eines weiteren npn-Transistors $T_{12}$ anzuschließen, dessen Emitter mit dem Bezugspunkt verbunden ist. Der Kollektoranschluß dieses Transistors $T_{12}$ bildet die gewünschte Stromquelle, wenn der Widerstand $R_8$ etwa den halben Wert des Widerstandes $R_7$ und der Transistor $T_{12}$ gegenüber den anderen npn-Transistoren die 4-fache Basis-Emitter-Fläche aufweist.

Die in den Ausführungsbeispielen gezeigten Faltungsverstärker 1 können nun mit Vorteil zum Aufbau eines A/D-Faltungsumsetzer in Kaskadenstruktur gemäß Figur 10 verwendet werden. Eine Stromquelle $Q_e$ erzeugt das Eingangssignal $I_{e1}$, das der ersten Stufe $S_1$ des D/A-Faltungsumsetzers zugeführt wird. Diese Stufe $S_1$ und im übrigen auch die nachfolgenden Stufen $S_2$ bis $S_n$ enthalten einen Faltungsverstärker 1 der oben beschriebenen Art sowie einen Komparator $K_i$ (i=1,...n). Vom Eingangsstrom $I_{e1}$ wird in der ersten Zelle $S_1$ der Strom $I_{r1}$ der Referenzstromquelle $Q_{ref1}$ subtrahiert, wobei der Wert dieses Referenzstromes $I_{r1} = 1/2 \times I_{emax}$ beträgt und $I_{emax}$ der maximale Eingangsstrom darstellt. Das dadurch erzeugte Differenzstromsignal $I_d$ wird den Stromquellen 2 und 3 als auch dem Komparator $K_1$ zugeführt. Der Nulldurchgang dieses Differenzstromes $I_d$ wird von dem Komparator $K_1$ detektiert, wodurch an dessen Ausgang ein logisches Signal $D_1$ erscheint, das aussagt, ob die Stromdifferenz $I_d$ positiv oder negativ ist. Der Ausgangsstrom $I_{a1}$ des Faltungsverstärkers 1 wird als Eingangssignal $I_{e2}$ dem Eingang der zweiten Stufe $S_2$ zugeführt, wo dieses Signal der gleichen Verarbeitung unterzogen wird. Aufgrund der Faltung des Eingangssignales $I_{e1}$ in der ersten Stufe $S_1$ wird der Kipppunkt zweimal durchlaufen (vergleiche Figur 2c). Am Ausgang des Komparators $K_2$ dieser zweiten Stufe $S_2$ erscheint das zweite Binärsignal $D_2$. Das Ausgangssignal $I_{a2}$ des Faltungsverstärkers 1 dieser zweiten Stufe $S_2$ wird wieder der nächsten Stufe zugeführt, bis in dieser Weise die letzte Stufe $S_n$ erreicht wird. In dieser letzten Stufe $S_n$ erzeugt der Faltungsverstärker 1 kein Ausgangssignal mehr. Als Vergleichsspannung für die Komparatoren $K_1$ bis $K_n$ dient eine Referenzspannung $U_{ref}$, die jeweils an einen Eingang dieser Komparatoren geführt ist. Das an den Ausgängen dieser Komparatoren erhaltene Digitalwort $D_1$, $D_2$, ..., $D_n$ stellt das digitalisierte Analogsignal $I_e$ in Gray-Kode dar.

## Patentansprüche

1. Faltungsverstärker (1), dem als Eingangssignal ein Stromsignal ($I_e$) zugeführt wird und der als Ausgangssignal ein Stromsignal ($I_a$) mit V-förmigen Verlauf erzeugt, wobei zur Bildung eines Stromdifferenzsignales ($I_d$) aus dem Stromsignal ($I_e$) und einem Referenzstrom ($I_{ref}$) eine diesen Referenzstrom ($I_{ref}$) erzeugende Referenzstromquelle ($Q_{ref}$) vorgesehen ist, gekennzeichnet durch folgende Merkmale:

   a) Das Stromdifferenzsignal ($I_d$) wird als Steuersignal sowohl einer ersten stromgesteuerten Stromquelle (2), die das Vorzeichen des Steuersignales umkehrt, als auch einer zweiten stromgesteuerten Stromquelle (3), die das Vorzeichen des Steuersignales beibehält, zugeführt, wobei

   b) bei positivem Vorzeichen des Stromdifferenzsignales ($I_d > 0$) die erste Stromquelle (2) diesen Strom ($I_d$) übernimmt und bei negativem Vorzeichen des Stromdifferenzsignales ($I_d < 0$) die zweite Stromquelle (3) diesen Strom ($I_d$) übernimmt und

   c) die beiden Ausgänge der ersten und zweiten Stromquelle (2, 3) mit dem Ausgang (A, A') des Faltungsverstärkers (1) verbunden sind.

2. Faltungsverstärker nach Anspruch 1, dadurch gekennzeichnet, daß eine dritte stromgesteuerte Stromquelle (4) mit Vorzeichenumkehr vorgesehen ist, deren Eingang die Summe der beiden Ausgangsströme ($I_1$, $I_2$) der ersten und zweiten Stromquelle (2, 3) zugeführt wird und deren Ausgang den Ausgang (A) des Faltungsverstärkers (1) bildet.

3. Faltungsverstärker nach Anspruch 2, dadurch gekennzeichnet, daß die erste und dritte Stromquelle (2, 4) als Stromspiegel ausgebildet sind.

4. Faltungsverstärker nach einem der vorangehenden Ansprüche, dadurch gekennzeichnet, daß der Verstärkungsfaktor der zweiten Stromquelle (3) den Wert 1 aufweist.

5. Faltungsverstärker nach Ansprüche 2 bis 4, dadurch gekennzeichnet, daß der Spiegelfaktor der ersten Stromquelle (2) den Wert 1 aufweist.

6. Faltungsverstärker nach einem der Ansprüche 3 bis 5, dadurch gekennzeichnet, daß der Spiegelfaktor der dritten Stromquelle (4) den Wert 2 aufweist.

7. Faltungsverstärker nach einem der vorangehenden Ansprüche, dadurch gekennzeichnet, daß die zweite Stromquelle (3) als Bipolartransistor ($T_3$) in Basisschaltung ausgeführt ist.

8. Faltungsverstärker nach Anspruch 7, dadurch gekennzeichnet, daß der Emitter des Transistors ($T_3$) den Eingang und der Kollektor des Transistors ($T_3$) den Ausgang bilden und die Basis mit einer ersten Hilfsspannungsquelle ($Q_{H1}$) verbunden ist.

9. Faltungsverstärker nach einem der Ansprüche 6 bis 8, dadurch gekennzeichnet, daß die dritte Stromquelle (3) aus einem als Diode geschalteten Eingangstransistor ($T_4$) und mit gegenüber diesem Eingangstransistor ($T_4$) identischen Ausgangstransistor ($T_5$) aufgebaut ist.

10. Faltungsverstärker nach einem der Ansprüche 6 bis 8, dadurch gekennzeichnet, daß die dritte Stromquelle (4) aus einem als Diode geschalteten Eingangstransistor ($T_4$) und einem Ausgangstransistor ($T_5$) mit gegenüber dem Eingangstransistor ($T_4$) doppelter Basis-Emitter-Fläche ausgebildet ist.

11. Faltungsverstärker nach einem der Ansprüche 6 bis 8, dadurch gekennzeichnet, daß die dritte Stromquelle (4) aus einem als Diode geschalteten Eingangstransistor ($T_4$) und mehr als zwei mit dem Eingangstransistor ($T_4$) identischen Ausgangstransistoren ($T_5$) aufgebaut ist und daß die verbundenen Emitter dieser Ausgangstransistoren ($T_5$) zur Einstellung des Stromverstärkungsfaktors an eine zweite Hilfsspannungsquelle ($Q_{H2}$) angeschlossen sind.

12. Faltungsverstärker nach einem der Ansprüche 6 bis 8, dadurch gekennzeichnet, daß die dritte Stromquelle (4) aus einem als Diode geschalteten Eingangstransistor ($T_4$) und mit gegenüber dem Eingangstransistor ($T_4$) mehr als doppelter Basis-Emitter-Fläche ausgebildeten Ausgangstransistor ($T_5$) aufgebaut ist und die verbundenen Emitter dieses Ausgangstransistors ($T_5$) zur Einstellung des Stromverstärkungsfaktors an eine zweite Hilfsspannungsquelle ($Q_{H2}$) angeschlossen sind.

13. Faltungsverstärker nach Anspruch 11 oder 12, dadurch gekennzeichnet, daß die zweite Hilfsspannungsquelle ($Q_{H2}$) als Stromspiegel ausgebildet ist, wobei die Hilfsspannung ($U_{H2}$) am Emitter des Ausgangstransistors ($T_{11}$) dieses Stromspiegels abgegriffen wird, daß der Eingang und der Ausgang dieses Stromspiegels mit je einer Referenzstromquelle ($Q_2$, $Q_3$) verbunden sind und daß der Eingang eines Regelverstärkers ($T_{12}$) mit dem Ausgang des Stromspiegels und der Ausgang des Regelverstärkers mit dem Emitter des Ausgangstransistors ($T_{11}$) dieses Stromspiegels verbunden ist.

14. Faltungsverstärker nach Anspruch 13, dadurch gekennzeichnet, daß der Regelverstärker durch einen Transistor ($T_{12}$) gebildet wird, dessen Eingang der Basisanschluß, dessen Ausgang der Kollektoranschluß ist und dessen Kollektor über einen Widerstand ($R_6$) mit der Versorgungsspannung ($U_B$) verbunden ist.

15. Faltungsverstärker nach einem der vorangehenden Ansprüche, dadurch gekennzeichnet, daß die erste Hilfsspannungsquelle ($Q_{H1}$) aus der Reihenschaltung zweier Transistordioden ($T_6$, $T_7$) besteht, die von einer Stromquelle ($Q_1$) gespeist wird, wobei dem Kollektor der mit der Stromquelle ($Q_1$) verbundenen Transistordiode ($T_7$) ein Widerstand ($R_7$) vorgeschaltet ist und am Verbindungspunkt von diesem Widerstand ($R_7$) und dem Kollektor die erste Hilfsspannung ($U_{H1}$) abgegriffen wird.

16. Faltungsverstärker nach Anspruch 15, dadurch gekennzeichnet, daß dem Kollektor der zweiten Transistordiode ($T_6$) ein weiterer Widerstand ($R_8$) vorgeschaltet ist und daß am Verbindungspunkt dieses Widerstandes ($R_8$) mit dem Kollektor die Basis eines weiteren Transistors ($T_{12}$) angeschlossen ist, der als Stromquelle zur Ruhestromkompensation dient.

17. A/D-Kaskadenumsetzer mit wenigstens zwei Stufen ($S_1$, ..., $S_n$) gekennzeichnet durch folgende Merkmale:

    a) Jede Stufe ($S_1$, ..., $S_n$) umfasst einen Faltungsverstärker (1) gemäß einer der vorhergehenden Ansprüche sowie einen Komparator ($K_1$, ..., $K_n$), wobei das Ausgangssignal ($I_a$) des Faltungsverstärkers (1) das Eingangssignal für die nachfolgende Stufe bildet,

    b) ferner ist eine Referenzspannung ($U_{ref}$) vorgesehen, die an einen Eingang des Komparators ($K_1$, ..., $K_n$) jeder Stufe ($S_1$, ..., $S_n$) angelegt wird und

    c) schließlich wird dem anderen Eingang des Komparators ($K_1$, ..., $K_n$) einer Stufe ($S_1$, ..., $S_n$) das von dem Faltungsverstärker (1) der gleichen Stufe erzeugte Stromdifferenzsignal ($I_d$)

zugeführt, wobei der Ausgang des Komparators ($K_1$, ..., $K_n$) einen 1-Bit-Ausgang ($D_1$, ..., $D_n$) bildet.

## Claims

1. A folding amplifier (1) to which a current signal ($I_e$) is supplied as an input signal and by means of which a current signal ($I_a$) having a V-shaped waveform is produced as the output signal, wherein there is provided a reference current source ($Q_{ref}$) which produces a reference current ($I_{ref}$) so that a current difference signal ($I_d$) may be formed from the current signal ($I_e$) and said reference signal ($I_{ref}$), characterised by the following features:

   a) the current difference signal ($I_d$) is supplied in the form of a control signal to a first current controlled current source (2) which reverses the prefix sign of the control signal, and also to a second current controlled current source (3) which retains the prefix sign of the control signal, whereby

   b) the first current source (2) accepts the current difference signal ($I_d$) when the prefix sign thereof is positive ($I_d > 0$), whereas the second current source (3) accepts the current difference signal ($I_d$) when the prefix sign thereof is negative ($I_d < 0$) and

   c) the two outputs of the first and second current sources (2, 3) are connected to the output (A, A') of the folding amplifier (1).

2. A folding amplifier in accordance with Claim 1, characterised in that there is provided a third current controlled current source (4) with prefix sign reversal, to the input of which the sum of the two output currents ($I_1$, $I_2$) of the first and second current sources (2, 3) is supplied, and the output of which forms the output (A) of the folding amplifier (1).

3. A folding amplifier in accordance with Claim 2, characterised in that the first and third current sources (2, 4) are current mirrors.

4. A folding amplifier in accordance with any of the preceding Claims, characterised in that the amplification factor of the second current source (3) has the value 1.

5. A folding amplifier in accordance with any of the Claims 2 to 4, characterised in that the imaging factor of the first current source (2) has the value 1.

6. A folding amplifier in accordance with any of the Claims 3 to 5, characterised in that the imaging factor of the third current source (4) has the value 2.

7. A folding amplifier in accordance with any of the preceding Claims, characterised in that the second current source (3) is implemented in the form of a bipolar transistor ($T_3$) having a common base configuration.

8. A folding amplifier in accordance with Claim 7, characterised in that the emitter of the transistor ($T_3$) forms the input and the collector of the transistor ($T_3$) forms the output whilst the base is connected to a first auxiliary voltage source ($Q_{H1}$).

9. A folding amplifier in accordance with any of the Claims 6 to 8, characterised in that the third current source (3) is formed by an input transistor ($T_4$) wired as a diode and has an output transistor ($T_5$) that is identical to said input transistor ($T_4$).

10. A folding amplifier in accordance with any of the Claims 6 to 8, characterised in that the third current source (4) is formed by an input transistor ($T_4$) wired as a diode and has an output transistor ($T_5$) having a base-emitter surface area of twice the size of that of said input transistor ($T_4$).

11. A folding amplifier in accordance with any of the Claims 6 to 8, characterised in that the third current source (4) is formed by an input transistor ($T_4$) wired as a diode and has more than two output transistors ($T_5$) that are identical with said input transistor ($T_4$), and that the connected emitters of said output transistors ($T_5$) are connected to a second auxiliary voltage source ($Q_{H2}$) for the purposes of establishing the current amplification factor.

12. A folding amplifier in accordance with any of the Claims 6 to 8, characterised in that the third current source (4) is formed by an input transistor ($T_4$) wired as a diode and has an output transistor ($T_5$) having a base-emitter surface area of more than twice the size of that of said input transistor ($T_4$), and that the connected emitters of said output transistor ($T_5$) are connected to a second auxiliary voltage source ($Q_{H2}$) for the purposes of establishing the current amplification factor.

13. A folding amplifier in accordance with Claim 11 or 12, characterised in that the second auxiliary voltage source ($Q_{H2}$) is in the form of a current mirror wherein the auxiliary voltage ($U_{H2}$) is tapped off from the emitter of the output transistor ($T_{11}$) of this current mirror, that the input and the output of this current mirror are each connected to a reference current source ($Q_2$, $Q_3$), and that the input of a servo amplifier ($T_{12}$) is connected to the output of the current mirror and the output of the servo amplifier is connected to the emitter of the output transistor ($T_{11}$) of this current mirror.

**14.** A folding amplifier in accordance with Claim 13, characterised in that the servo amplifier is implemented as a transistor ($T_{12}$) whose base connection forms the input and whose collector connection forms the output, said collector being connected via a resistor ($R_6$) to the supply voltage ($U_B$).

**15.** A folding amplifier in accordance with any of the preceding Claims, characterised in that the first auxiliary voltage source ($Q_{H1}$) comprises two series connected transistor-diodes ($T_6$, $T_7$) that are fed by a current source ($Q_1$), wherein a resistor ($R_7$) is connected to the collector of the transistor-diode ($T_7$) that is connected to the current source ($Q_1$), and the first auxiliary voltage ($U_{H1}$) is tapped off from the connecting point between this resistor ($R_7$) and the collector.

**16.** A folding amplifier in accordance with Claim 15, characterised in that the a further resistor ($R_8$) is connected to the collector of the second transistor-diode ($T_6$) and that the base of a further transistor ($T_{12}$) serving as a quiescent current compensating current source is connected to the connecting point between said resistor ($R_8$) and the collector.

**17.** An A/D cascade converter having at least two stages ($S_1$, ..., $S_n$) characterised by the following features:

a) each stage ($S_1$, ..., $S_n$) comprises a folding amplifier (1) in accordance with any of the preceding Claims and a comparator ($K_1$ ..., $K_n$), wherein the output signal ($I_a$) of the folding amplifier (1) forms the input signal for the succeeding stage,

b) furthermore, a reference voltage ($U_{ref}$) is provided which is applied to an input of the comparator ($K_1$ ..., $K_n$) in each stage ($S_1$, ..., $S_n$), and

c) finally, the current difference signal ($I_d$) produced by the folding amplifier (1) of a stage is supplied to the other input of the comparator ($K_1$ ..., $K_n$) of the same stage ($S_1$, ..., $S_n$), whereby the output of the comparator ($K_1$ ..., $K_n$) forms a 1 bit output ($D_1$, ..., $D_n$).

**Revendications**

**1.** Amplificateur de convolution (1), auquel est envoyé en tant que signal d'entrée un signal de courant ($I_e$)

et qui produit, en tant que signal de sortie, un signal de courant ($I_a$) possédant une allure en forme de V, et dans lequel pour la formation d'un signal de différence de courant ($I_i$) à partir du signal de courant ($I_e$) et d'un courant de référence ($I_{ref}$) il est prévu une source de courant de référence ($Q_{ref}$) qui produit ce courant de référence ($I_{ref}$), caractérisé par les caractéristiques suivantes :

a) le signal de différence de courant ($I_e$) est envoyé en tant que signal de commande aussi bien à une première source de courant (2), dont le courant est commandé et qui inverse le signe du signal de commande, qu'à une seconde source de courant (3), dont le courant est commandé ce qui maintient le signe du signal de commande, auquel cas
b) dans le cas d'un signe positif du signal de différence de courant ($I_d > 0$), la première source de courant (2) prend en charge ce courant ($I_d$) et, dans le cas d'un signe négatif du signal de différence de courant ($I_d < 0$), la seconde source de courant (3) prend en charge de courant ($I_d$), et
c) les deux sorties des première et seconde sorties de courant (2,3) sont reliées à la sortie (A,A') de l'amplificateur de convolution (1).

**2.** Amplificateur de convolution selon la revendication 1, caractérisé en ce qu'il est prévu une troisième source de courant (4), dont le courant est commandé et qui présente une inversion de signe et à l'entrée de laquelle est envoyée la somme des deux courants de sortie ($I_1$, $I_2$) des première et seconde sources de courant (2,3) et dont la sortie forme la sortie (A) de l'amplificateur de convolution (1).

**3.** Amplificateur de convolution selon la revendication 2, caractérisé en ce que les première et troisième sources de courant (2,4) sont agencées sous la forme d'un miroir de courant.

**4.** Amplificateur de convolution selon l'une des revendications précédentes, caractérisé en ce que le facteur d'amplification de la seconde source de courant (3) possède la valeur 1.

**5.** Amplificateur de convolution selon les revendications 2 à 4, caractérisé en ce que le facteur de symétrie de la première source de courant (2) possède la valeur 1.

**6.** Amplificateur de convolution selon l'une des revendications 3 à 5, caractérisé en ce que le facteur de symétrie de la troisième source de courant (4) possède la valeur 2.

**7.** Amplificateur de convolution selon l'une des revendications précédentes, caractérisé en ce que la seconde source de courant (3) est agencée sous la forme d'un transistor bipolaire ($T_3$) monté en base commune.

8. Amplificateur de convolution selon la revendication 7, caractérisé en ce que l'émetteur du transistor ($T_1$) forme l'entrée, et que le collecteur du transistor ($T_3$) forme la sortie et que la base est reliée à une première source de tension auxiliaire ($Q_{H1}$).

9. Amplificateur de convolution selon l'une des revendications 6 à 8, caractérisé en ce que la troisième source de courant (4) est constituée par un transistor d'entrée ($T_4$) branché en tant que diode et par un transistor de sortie ($T_5$) identique à ce transistor d'entrée ($T_4$).

10. Amplificateur de convolution selon l'une des revendications 6 à 8, caractérisé en ce que la troisième source de courant (4) est constituée par un transistor d'entrée ($T_4$) branché en tant que diode et par un transistor de sortie ($T_5$) possédant une surface base - émetteur double de celle du transistor d'entrée ($T_4$).

11. Amplificateur de convolution selon l'une des revendications 6 à 8, caractérisé en ce que la troisième de courant (4) est constituée par un transistor d'entrée ($T_4$) branché en tant que diode et par plus de deux transistors de sortie ($T_5$) identiques au transistor d'entrée ($T_4$) et que les émetteurs reliés de ces transistors de sortie ($T_5$) sont connectés, pour le réglage du facteur d'amplification de courant, à une seconde source de tension auxiliaire ($Q_{H2}$).

12. Amplificateur de convolution selon l'une des revendications 6 à 8, caractérisé en ce que la troisième source de courant (4) est constituée par un transistor d'entrée ($T_4$) branché en diode et par un transistor de sortie ($T_5$) réalisé avec une surface base-émetteur égale à plus du double de celle du transistor d'entrée ($T_5$), et que les émetteurs de ce transistor de sortie ($T_5$) sont connectés, pour le réglage du facteur d'amplification de courant, à une seconde source de tension auxiliaire ($Q_{H2}$).

13. Amplificateur de convolution selon la revendication 11 ou 12, caractérisé en ce que la seconde source de tension auxiliaire ($Q_{H2}$) est agencée sous la forme d'un miroir de courant, la tension auxiliaire ($U_{H2}$) étant prélevée sur l'émetteur de sortie ($T_{11}$) de ce miroir de courant, que l'entrée et la sortie de ce miroir de courant sont reliées à des sources de courant de référence respectives ($Q_2$, $Q_3$), et que l'entrée d'un amplificateur de régulation ($T_{12}$) est reliée à la sortie du miroir de courant et que la sortie de l'amplificateur de régulation est reliée à l'émetteur du transistor de sortie ($T_{11}$) de ce miroir de courant.

14. Amplificateur de convolution selon la revendication 13, caractérisé en ce que l'amplificateur de régulation est formé par un transistor ($T_{12}$), dont l'entrée est la borne de base, dont la sortie est la borne de collecteur et dont le collecteur est relié à la tension d'alimentation ($U_B$) par l'intermédiaire d'une résistance ($R_6$).

15. Amplificateur de convolution selon l'une des revendications précédentes, caractérisé en ce que la première source de tension auxiliaire ($Q_{H1}$) est constituée par le circuit série formé de deux diodes formées de transistors ($T_6$, $T_7$), et qui est alimentée par une source de courant ($Q_1$), une résistance ($R_7$) étant branché en amont du collecteur de la diode formée d'un transistor ($T_7$), reliée à la source de courant ($Q_1$), tandis que la première tension auxiliaire ($U_{H1}$) est prélevée au niveau du point de jonction entre cette résistance ($R_7$) et le collecteur.

16. Amplificateur de convolution selon la revendication 15, caractérisé en ce qu'une autre résistance ($R_8$) est branchée en amont du collecteur de la seconde diode formée d'un transistor ($T_6$) et qu'au point de jonction de cette résistance ($R_8$) avec le collecteur, est connectée la base d'un autre transistor ($T_{12}$), qui est utilisé en tant que source de courant pour la compensation du courant de repos.

17. Convertisseur analogique/numérique en cascade comportant au moins deux étages ($S_1$ ..., $S_n$), caractérisé par les caractéristiques suivantes :

   a) chaque étage ($S_1$ ..., $S_n$) comprend un amplificateur de convolution (1) selon l'une des revendications précédentes ainsi qu'un comparateur ($K_1$, ..., $K_n$), le signal de sortie ($I_a$) de l'amplificateur de convolution (1) formant le signal d'entrée pour l'étage suivant,
   b) en outre il est prévu une tension de référence ($U_{ref}$), qui est appliquée à une entrée du convertisseur ($K_1$, ..., $K_n$) de chaque étage ($S_1$ ..., $S_n$), et
   c) enfin à l'autre entrée est envoyé à l'autre entrée du comparateur ($K_1$, ..., $K_n$) d'un étage ($S_1$ ..., $S_n$) le signal de différence de courant ($I_d$) produit par l'amplificateur de convolution (1) du même étage, la sortie du comparateur ($K_1$, ..., $K_n$) formant une sortie à 1 bit ($D_1$, ..., $D_n$).

FIG. 1

FIG.2 a

FIG.2 b

FIG.2 c

FIG.3 a

EP 0 729 225 B1

FIG. 3b

FIG.4

11

EP 0 729 225 B1

FIG.5

FIG.6

FIG.7

FIG.8

12

EP 0 729 225 B1

FIG. 9

FIG. 10